# EUROPÄISCHE PATENTSCHRIFT

(11) **EP 3 579 671 B1**
(45) Veröffentlichungstag und Bekanntmachung des Hinweises auf die Patenterteilung: **15.03.2023**
(21) Anmeldenummer: 18175982.0
(22) Anmeldetag: 05.06.2018
(51) Int. Cl.: H05K 5/04, H02B 1/28, H05K 5/00

(54) **GEHÄUSE DER SCHUTZART DRUCKFESTE KAPSELUNG**
HOUSING FOR PRESSURE-PROOF ENCLOSURE
BOÎTIER DU TYPE DE PROTECTION À BLINDAGE RÉSISTANT À LA PRESSION (ANTIDÉFLAGRANT)

(43) Veröffentlichungstag der Anmeldung: 11.12.2019
(73) Patentinhaber: R. STAHL Schaltgeräte GmbH, 74638 Waldenburg (DE)
(72) Erfinder: KONDRUS, Elena, 74653 Künzelsau (DE); SCHMITT, Jürgen, 74613 Öhringen (DE); SEKINGER, Natascha, 74629 Baierbach (DE); WALCH, Otto, 74582 Gerabronn (DE); KOCHENDÖRFER, Christian, 74523 Schwäbisch Hall (DE); LIMBACHER, Bernd, 74523 Schwäbisch Hall (DE)
(74) Vertreter: Rüger Abel Patentanwälte PartGmbB

(56) Entgegenhaltungen:
- EP-A2- 1 107 656
- DE-T5-112010 005 085
- US-A- 3 974 933
- US-A1- 2013 240 220

## Beschreibung

Die Erfindung betrifft ein Gehäuse der Schutzart druckfeste Kapselung zur Aufnahme von elektrischen oder elektronischen oder auch sonstigen Komponenten, die Zündquellen darstellen können. Insbesondere betrifft die Erfindung ein großvolumiges Gehäuse mit mehreren, vorzugsweise mehreren 10 l, Gehäusevolumen zum Einsatz in explosionsgefährdeter Umgebung.

Aus der US 4,180,177 ist ein Gehäuse mit einem Gehäusekörper und einer daran vorgesehenen Tür vorgesehen, die bedarfsweise Zugang zum Gehäuseinnenraum gewährt. Die Tür ist durch Scharniere an dem Gehäusekörper schwenkbar gelagert. Zum sicheren Verschluss der Gehäuseöffnung ist sie entlang ihres gesamten Randes mittels voneinander beabstandeter Bolzen mit dem Gehäusekörper verschraubt. Zum Anbringen der Bolzen sind am Rand der Tür Bohrlöcher erforderlich. Das Gehäuse muss, um Explosionssicherheit zu gewähren, so aufgebaut sein, dass alle Spalte, die vom Gehäuseinnenraum in die Umgebung führen, eine Mindestweite unterschreiten und eine Mindestlänge überschreiten, damit eine in dem Gehäuseinnenraum gezündete Explosion nicht zur Fortpflanzung der Explosion außerhalb des Gehäuses führt. Weder Flammen noch heiße Gase noch glühende Partikel dürfen durch den zwischen der Tür und dem Gehäuse gebildeten Spalt hindurch nach außen gelangen. Weiter ist aus der DE 11 2010 005 085 T5 ein explosionssicheres Gehäuse bekannt, das hinsichtlich der zu erwartenden Explosionsdrücke dicht ausgebildet ist. Es umfasst einen massiven Gehäusekörper mit einem eine Gehäuseöffnung umgebenden Flansch, auf dem ein massiver Deckel aufliegt. Um den Deckel dicht an dem Gehäuseflansch zu halten, sind auf den äußeren Rand des Deckels und den Flansch Gehäuseklemmen aufgesetzt, die eine trapezförmige Nut aufweisen. Diese trapezförmige Nut nimmt den Gehäuseflansch und den äußeren Rand des darauf liegenden randseits abgeschrägten Deckels auf. Um die Gehäuseklemme festzuziehen und somit den Deckelrand gegen den Flansch zu pressen, können in einer ersten Ausführung Spannschrauben vorgesehen sein, die in eine Gewindesackbohrung des Gehäuseflansches eingeschraubt sind. Diese Gewindesackbohrung weist eine Öffnungsrichtung parallel zu der Auflagefläche des Flansches auf, auf der Deckel liegt. Spannschrauben durchsetzen die Gehäuseklemme und drücken diese zu dem Gehäuse hin, um den Deckel unter Keilwirkung gegen den Flansch zu spannen. Alternative Spannsystem wie beispielsweise eine auf dem Deckel angeordnete Kniehebelspanneinrichtung oder eine außen an dem Flansch angebrachte Kniehebelanordnung werden ebenfalls vorgeschlagen.

Aus der US 2013/0240220 A1 ist ein explosionssicheres Gehäuse mit einem Gehäusekörper bekannt, der einen ringsum laufenden Flansch mit einer ebenen Dichtfläche aufweist. Auf diesen ist ein entsprechend massiv ausgebildeter Deckel aufsetzbar. In dem Flansch ist eine Reihe von Gewindeöffnungen ausgebildet, denen entsprechende Befestigungsöffnungen des Deckels zugeordnet sind. Der Deckel kann durch Befestigungsschrauben fixiert werden, die die Befestigungsöffnungen durchsetzen und in die Gewindeöffnungen des Gehäuseflansches eingeschraubt sind.

Es ist Aufgabe der Erfindung, ein solches Gehäuse zu verbessern.

Diese Aufgabe wird mit dem Gehäuse nach Anspruch 1 gelöst:
Das erfindungsgemäße Gehäuse umfasst einen Gehäusekörper, der einen Innenraum zur Aufnahme elektrischer oder elektronischer Komponenten oder auch sonstiger Elemente umgrenzt. Der Gehäusekörper weist eine Öffnung auf, die von einem Flansch umgrenzt ist. Der Flansch ist so orientiert, dass er von außen hintergreifbar ist. Die von dem Flansch umgrenzte Öffnung ist von einem Deckel verschlossen, dessen Rand auf dem Flansch aufliegt und mit diesem vorzugsweise abschließt. Um den Rand und den Flansch sicher zusammenzuhalten, ist eine Anzahl Klemmen vorgesehen, die entlang des Flansches und des Randes in Abständen zueinander angeordnet sind, wobei jede Klemme den Rand und den Flansch umgreift und in geschlossenem Zustand den Rand mit oder ohne dazwischen angeordneter Dichtung gegen den Flansch spannt.

Nach diesem Konzept ergibt sich eine gute Zugänglichkeit des Innenraums. Der nach außen gerichtete Flansch verringert die lichte Weite der Öffnung nicht, so dass uneingeschränkter Zugang zum Innenraum gewährt ist.

Außerdem kann die Anzahl der Klemmen auf einfache Weise variiert oder festgelegt werden ohne konstruktive oder fertigungstechnische Veränderungen an dem Gehäuse vornehmen zu müssen. Eine Anpassung an verschiedene Gegebenheiten ist leicht möglich.

Insbesondere vermeidet das erfindungsgemäße Konzept die sonst beim Stand der Technik gegebene Notwendigkeit der Anbringung von Durchbrüchen oder Löchern zur Aufnahme von Befestigungsbolzen. Damit wird es möglich, die Breite des Flansches auf die notwendige Spaltlänge zu begrenzen. Zugaben, die sonst erforderlich wären, um die notwendige Spaltlänge auch im Bereich der Bolzenlöcher sicherzustellen sind nicht nötig.

Das erfindungsgemäße Konzept eignet sich insbesondere für besonders große Gehäuse, bei denen die Öffnung größer als ein 1/4 m², größer als 1/2 m² und insbesondere größer als 1 m² sein kann. Statische Überbestimmungen, wie sie insbesondere bei großflächigen Deckeln an einer Vielzahl von Befestigungsbolzen auftreten könnten, werden sicher ausgeschlossen. Die an dem Rand angebrachten Klemmen spannen den Rand des Deckels auch dann sicher gegen den Flansch, wenn der Flansch und der Rand des Deckels zum Beispiel infolge von Temperaturänderungen in der Positionierung zueinander eine spürbare Toleranz haben.

Der Flansch ist vorzugsweise als ebener Flansch mit einer ebenen Flanschfläche ausgebildet. Der Deckel weist eine dazu passende und z.B. ebenfalls ebene Randfläche auf, die unmittelbar oder unter Zwischenlage eine Dichtung mit der Flanschfläche in Anlage überführbar ist. Vorzugsweise haben die Randfläche und die Flanschfläche innen und/oder außen übereinstimmende Konturen. Der Deckel kann insgesamt eben ausgebildet sein oder auch eine Wölbung aufweisen, wenn dies erforderlich oder gewünscht ist. Prinzipiell ist es jedoch auch möglich, die Flanschfläche und die dazu passende Randfläche des Deckels uneben auszubilden, beispielsweise wenn sich die Öffnung über zwei Seiten des Gehäuses erstreckt.

Bei einer bevorzugten Ausführungsform ist der Deckel über wenigstens ein Scharnier mit dem Gehäusekörper verbunden. Er kann somit nach Art einer Klappe oder Tür geöffnet und geschlossen werden. In geschlossenem Zustand sichern die Klemmen den Deckel an dem Gehäuse. Vorzugsweise weisen die Scharniere ein Radialspiel auf, dessen Größe ausreicht, um die Position des geschlossenen Deckels an dem Gehäusekörper allein durch die Flächenanlage der Randfläche an der Flanschfläche zu bestimmen und somit den Spaltschluss nicht zu behindern.

Bedarfsweise können an dem Gehäusekörper und dem Deckel Positioniermittel zur deckungsgleichen Ausrichtung des Randes und des Flansches zueinander vorgesehen sein. Solche Positioniermittel können zum Beispiel durch eine oder mehrere Passstifte gebildet sein, die an dem Deckel oder an dem Flansch angebracht sind. Der Gehäusekörper oder der Deckel ist dann entsprechend mit einer Passbohrung versehen, durch die der Passstift in geschlossenem Zustand des Deckels greift, um den Deckel in der Sollposition zu sichern. Die Positioniermittel können an der Flanschfläche und der Randfläche oder auch außerhalb derselben vorgesehen sein. Durch die deckungsgleiche Ausrichtung von Flansch und Deckel zueinander wird der Spalt zwischen ihnen so definiert, dass die nötige Spaltlänge überall eingehalten und ein Zünddurchschlag so verhindert wird.

Die Klemmen sind an dem Gehäusekörper oder alternativ an dem Deckel unverlierbar, jedoch beweglich gehalten. Dazu ist die Klemme an dem Gehäusekörper oder an dem Deckel über eine Scharniereinrichtung um eine Schwenkachse schwenkbar sowie bedarfsweise auch verschiebbar gelagert.

Es sind Mittel vorgesehen, um die Klemme in der Öffnungsposition festzulegen, in der sie den Deckel freigibt. Dies erleichtert das Abnehmen des Deckels, indem die Klemmen nach ihrem Lösen alle in Öffnungsposition gehalten werden. Ebenso ist ein Mittel vorgesehen, das die Schließposition der beweglichen Klemmen festlegt. Montagefehler können dadurch minimiert werden. Der betreffende Monteur überführt die Klemme in ihre Schließposition und spannt die Klemme dann, um den Deckel an den Flansch zu befestigen. Das die Schließposition festlegende Mittel sorgt dabei dafür, dass die Klemme in ihrer gewünschten Soll-Position steht.

Jede Klemme weist typischerweise eine Spannfläche und ein dieser Spannfläche gegenüberliegendes Spannmittel auf. Unabhängig von der Anordnung und Lagerung der Klemme können als Spannmittel alle Einrichtungen dienen, die weder den Rand des Deckels noch den Flansch des Gehäusekörpers durchsetzen. Solche Spannmittel können Spannschrauben, Spannkeile, Spannexzenter oder dergleichen sein. Insbesondere kann es vorteilhaft sein, ein Spannmittel mit Kraftbegrenzungseinrichtung, insbesondere eine Spannschraube mit Drehmomentbegrenzungseinrichtung vorzusehen. Damit können gerade im Bereich druckfester Gehäuse mit Flachspalt die nötigen Zuhaltekräfte an dem Spalt sicher eingestellt werden. Zum Verschließen des Gehäuses werden viele Klemmen und somit viele Schrauben genutzt. Durch die Kraftbegrenzungseinrichtung wird sichergestellt, dass der Deckel sich nicht zu stark von dem Flansch abheben kann und der definierte Zündspalt nicht überschritten wird.

Zur Gewährleistung der sicheren Montage werden die Deckelschrauben immer mit einem vordefinierten Drehmoment angezogen. Infolge einer Rutschkupplung oder eines anderen Drehmomentbegrenzungsmittels zwischen Schraubenkopf und Schraubenschaft werden bei der Montage, Inbetriebnahme und im Rahmen von Wartungs- oder Reparaturarbeiten sonst erforderliche Drehmomentschlüssel überflüssig. Dies erhöht die Montagesicherheit. Gerade angesichts der großen Anzahl Klemmen und somit Schrauben wird das Schließen des Gehäuses vereinfacht, weil die zusätzliche Anwendung von Drehmomentschlüsseln und die Überprüfung der korrekten Anzugsdrehmomente überflüssig wird.

Vorteilhafte Ausführungsformen der Erfindung ergeben sich aus der Zeichnung, der Beschreibung oder Ansprüche. In der Zeichnung zeigen:
Figur 1 ein erfindungsgemäßes Gehäuse, in schematisierter Perspektivdarstellung,
Figur 2 eine Klemme zum Befestigen des Deckels an dem Gehäuse, in schematisierter Seitenansicht,
Figur 3 eine abgewandelte Ausführungsform der Klemme nach Figur 2,
Figur 4 die Klemme nach Figur 3, in Schließposition in Draufsicht,
Figur 5 die Klemme nach Figur 4 in gleicher Position, jedoch teilweise aufgebrochener Darstellung,
Figur 6 die Klemme nach Figur 4 und 5 in Öffnungsposition,
Figur 7 eine weitere Ausführungsform einer Klemme in Schließposition,
Figur 8 eine Klemme mit Zugschraube, in Schließposition,
Figur 9 eine Klemme mit Kniehebelspanner in Schließposition,
Figur 10 eine Klemme mit Exzenterspanner in Schließposition
Figur 11 eine Klemme mit Keilspanner in Schließposition,
Figur 12 eine Spannschraube mit Rutschkupplung zur Kraftbegrenzung.

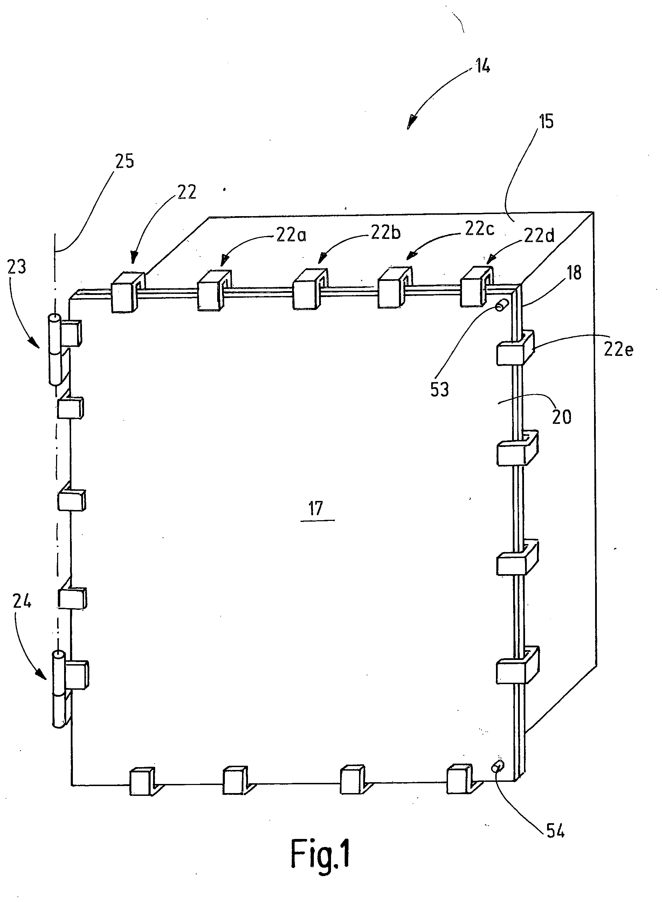

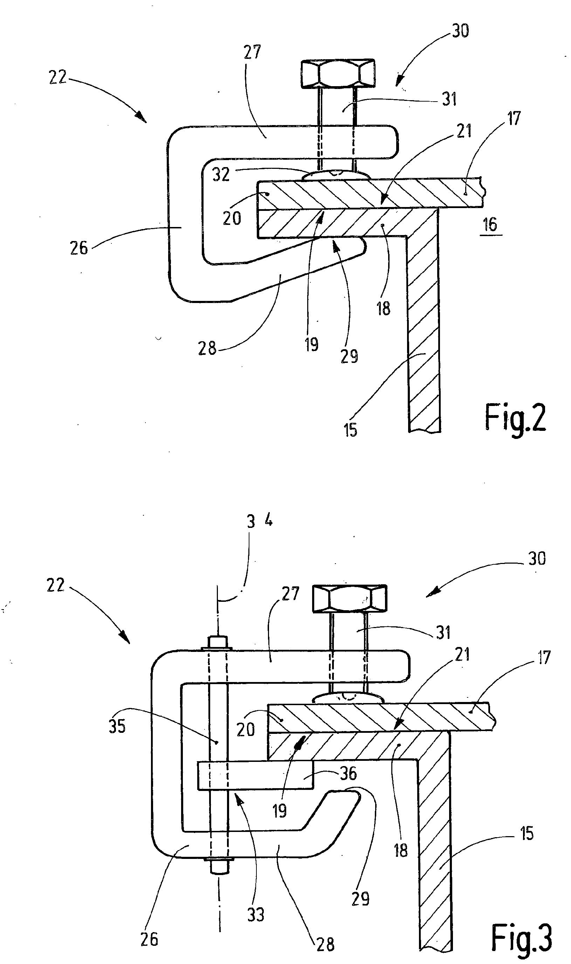

In Figur 1 ist ein Gehäuse 14 veranschaulicht, das nach der Schutzart ex-d ("Druckfeste Kapselung") ausgebildet ist. Es weist einen Gehäusekörper 15 mit einer Gehäuseöffnung 16 (siehe Figur 2) auf, die durch einen Deckel 17 verschlossen ist. Im vorliegenden Ausführungsbeispiel ist die Öffnung 16 viereckig und der Deckel 17 entsprechend rechteckig oder quadratisch. Die Erfindung ist jedoch nicht auf derartige Öffnungen und Gehäuse beschränkt. Die Öffnung kann ebenso gut rund, oval sowie polygonal von geraden oder gekrümmten Kanten umgrenzt sein.

Das Gehäuse 15 ist durch den Deckel 17 so abgeschlossen, dass es den Gehäuseinnenraum derart von der Umgebung trennt, dass kein Flammendurchschlag aus dem Innenraum in die Umgebung möglich ist. Dazu sind alle an dem Gehäuse 14 vorhandenen Spalte so eng und zugleich so lang, dass durchdringende Gase unter eine Zündtemperatur gekühlt werden, d.h. Flammen oder glühende Partikel nicht durchdringen können. Eine in dem Gehäuse 14 gezündete Explosion bleibt auf den Gehäuseinnenraum beschränkt und zündet eine womöglich in der Umgebung des Gehäuses 14 vorhandene explosible Atmosphäre nicht. Das Gehäuse ist jedoch nicht gasdicht. Es können eine oder mehrere Öffnungen vorgesehen sein, die mit sogenannten Flammensieben (Druckentlastungskörpern) versehen sind. Diese bestehen aus Körpern, die enge Kanäle und/oder Poren aufweisen und somit gasdurchlässig sind.

Zum Befestigen des Deckels 17 an dem Gehäusekörper 15 weist der Gehäusekörper 15 einen von der Öffnung 16 weg weisenden Flansch 18 auf, der rings um die Öffnung 16 führt. Der Flansch 18 weist eine dem Deckel 17 zugewandte Flanschfläche 19 auf, die vorzugsweise als Planfläche ausgebildet ist. Deckungsgleich mit dem Flansch 18 weist der Deckel 17 einen Rand 20 auf, der mit einer Randfläche 21 an der Flanschfläche 19 anliegt. Zwischen der Randfläche 21 und der Flanschflächen 19 kann bedarfsweise eine Dichtung angeordnet sein. Vorzugsweise liegen die Flanschfläche 19 und die Randfläche 21 jedoch dichtungslos aneinander. Der zwischen ihnen gebildete Spalt weist eine den Flammendurchschlag verhindernde Länge von zum Beispiel mehr als 20 mm auf, wobei die Spaltweite vorzugsweise entlang des gesamten Flanschs 18 Null ist oder ein geringes Maß von wenigen 100stel Millimeter nicht übersteigt. Der zwischen der Flanschfläche 19 und der Randfläche 21 gebildete Spalt ist jedoch typischerweise nicht gasdicht. Der Spalt kann auch durch eine Dichtung abgedichtet sein, die den Gasdurchtritt behindert oder sperrt. Diese Dichtung ist dann zwischen dem Flansch 18 und dem Rand 20 gehalten und komprimiert. Bei einer solchen Ausführungsform kann die Spaltlänge kürzer gewählt sein, als ohne Dichtung.

Zum explosionssicheren Halten des Deckels 17 an dem Gehäusekörper 15 sind entlang des gesamten Flansches 18 und des darauf liegenden Randes 20 Klemmen 22 (22a, 22b, 22c, 22d, 22e und weitere) vorgesehen, die vorzugsweise untereinander gleich ausgebildet sind und dazu dienen, den Rand 20 gegen den Flansch 18 zu drücken. Die nachfolgende Beschreibung der Klemme 22 gilt entsprechend für alle anderen Klemmen 22a, 22b, 22c, 22d, 22e und weitere, die entlang des Flansches 18 zum Beispiel in gleichen Abständen zueinander angeordnet sind. Alternativ können die Klemmen 22a, 22b, 22c, 22d, 22e belastungsentsprechend auch in unterschiedlichen Abständen zueinander angeordnet sein.

Der Deckel 17 kann von dem Gehäusekörper 15 getrennt oder über ein oder mehrere Scharniere 23, 24 mit dem Gehäusekörper 15 verbunden sein, wobei die Scharniere 23, 24 vorzugsweise eine gemeinsame Schwenkachse 25 festlegen. Die Schwenkachse kann an einer beliebigen Gehäuseseite angeordnet sein. Die Scharniere 23, 24 dienen lediglich zum Sichern des Deckels 17 in Offenstellung. Die Schließstellung des Deckels 17 wird durch die Klemmen 22 (22a, 22b, 22c, 22d, 22e und weitere) bewirkt.

Die Klemme 22 ist in Figur 2 in einfacher, nicht erfindungsgemäßer Ausführungsform veranschaulicht. Sie weist einen in Seitenansicht etwa c-förmigen oder u-förmigen steifen Körper 26 mit zwei den Rand 20 und den Flansch 18 umgreifenden Schenkeln 27, 28 auf. Die beiden Schenkels 27, 28 erstrecken sich von dem Rückenteil des Körpers 26 weg, wobei der Schenkel 28 den Flansch 18 untergreift und der Schenkel 27 den Rand 20 übergreift.

An dem Schenkel 28 ist eine Spannfläche 29 ausgebildet, die an der von der Flanschfläche 19 weg weisenden Seite des Flansches 18 anliegt. An dem anderen Schenkel 27 ist ein Spannmittel 30 gehalten, das hier beispielsweise in Gestalt einer Spannschraube 31 ausgebildet ist, die mit einem Fuß 32 versehen ist. Dieser ist an der Spannschraube vorzugsweise drehbar und gegebenenfalls auch kippbar gelagert und stützt sich auf der von der Randfläche 21 weg weisenden Seite des Rands 20 des Deckels 17 ab. Die Anordnung kann aber auch umgekehrt getroffen sein, indem die Spannfläche 29 an dem Deckel und das Spannmittel 30 an dem Flansch angreift.

Durch Aktivierung des Spannmittels, beispielsweise durch das Anziehen der Spannschraube 31, wird die Randfläche 21 fest gegen die Flanschfläche 19 geklemmt. Werden alle Klemmen 22 an dem Gehäuse 14 derart angezogen, ist der Deckel 17 fest an dem Gehäusekörper 15 gehalten und schließt den Innenraum desselben explosionssicher ab. Die seitlichen Abstände zwischen den Klemmen 22, 22a usw. sind dabei im Hinblick auf die Randsteifigkeit des Deckels 17 und die Steifigkeit des Flansches 18 so bemessen, dass auch zwischen den Klemmen bei einer Explosion im Gehäuseinnenraum keine unzulässige Spaltöffnung erfolgt.

Erfindungsgemäß ist die Klemme 22 unverlierbar an dem Gehäuse 15 gehalten, wie es beispielsweise Figur 3 veranschaulicht. Soweit diese Ausführungsform mit der vorbeschriebenen Ausführungsform des Gehäuses 15 und der Klemme 22 übereinstimmt wird unter Zugrundelegung der bereits eingeführten Bezugszeichen auf die vorige Beschreibung verwiesen, die entsprechend gilt. Ergänzend und zusätzlich wird auf Folgendes hingewiesen:

Zur unverlierbaren Lagerung der Klemme 22, 22a usw. an dem Gehäusekörper 15 ist die Klemme 22 über ein Scharnier 33 mit dem Flansch 18 bzw. dem Gehäusekörper 15 verbunden. Alternativ kann die Klemme 22, 22a usw. mit dem Deckel verbunden sein. Das Scharnier 33 legt eine Scharnierachse 34 fest, die vorzugsweise außerhalb des Flansches 18 und des Rands 20 insbesondere außerhalb der Flanschfläche 19 und der Randfläche 21 angeordnet ist. Die Scharnierachse 34 wird durch einen Stift 35 festgelegt, der in seitlichem Abstand zu dem Flansch 18 durch einen Halter 36 führt, der mit dem Flansch 18 (oder dem Rand 20) verbunden, zum Beispiel verschweißt ist. Der Stift ist dabei vorzugsweise mit beiden Enden in den Schenkeln 27, 28 gesichert und führt vorzugsweise axial verschiebbar durch eine Öffnung des Halters 36, wodurch die Klemme 22 entlang der Scharnierachse 34 beweglich ist.

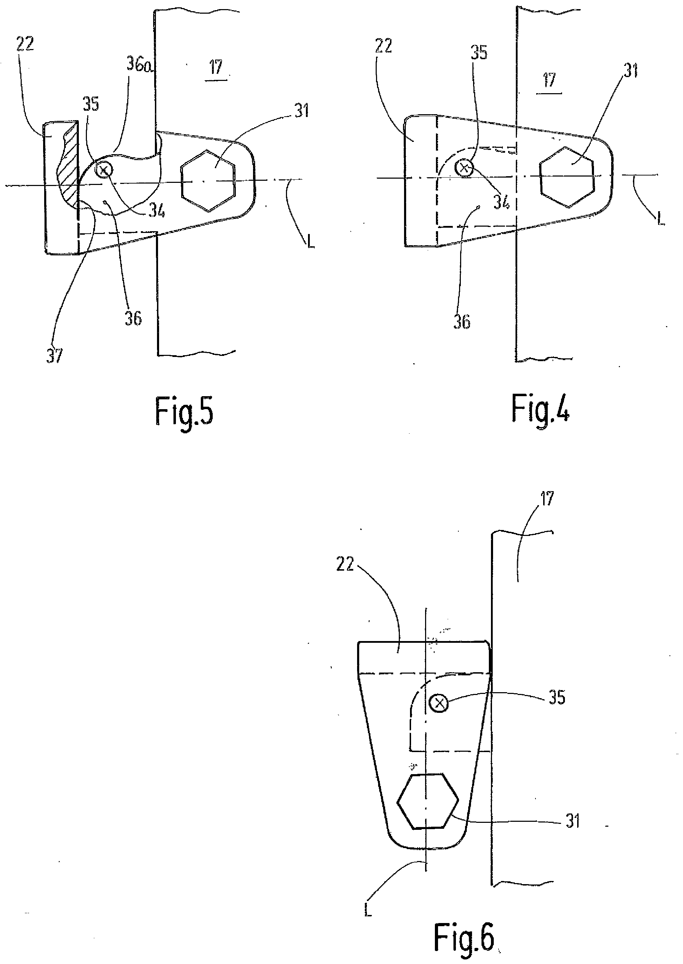

Wie Figur 4, 5 und 6 zeigen, ist die Scharnierachse 34 vorzugsweise außermittig zu dem Halter 36 angeordnet. Die bedeutet, dass die Scharnierachse 34 eine Mittellinie L der Klemme 22 nicht schneidet, die bei geschlossener Klemme 22 (Figur 4 und 5) rechtwinklig zu dem Flansch 18 steht und mittig durch die Klemmschraube 31 verläuft. Bei Klemme 22 in Öffnungsstellung (Figur 6) liegt der Stift 35 zwischen der Mittellinie 36 und dem Flansch 18. Die Klemme 22 ist in Richtung der Scharnierachse 34 verschiebbar und oben bzw. unten am Ende ihres Verschiebewegs. Der Halter 36 kann außerdem dazu genutzt werden, den Schwenkbereich der Klemme 22 zu begrenzen. Die Stirnfläche des Halters 36 kann so positioniert sein, dass die Klemme 22 in ihrer in den Figuren 4 und 5 veranschaulichten Schließposition an der Stirnseite des Halters 36 anliegt, an der eine Anlagefläche 37 ausgebildet ist. Die Klemme 22 kann aus der in Figur 6 veranschaulichten Position in die Position nach Figur 4 und 5 bewegt werden, in der der gerade, die Schenkel 27, 28 verbindende Teil des Körpers 20 an der Anlagefläche 37 anliegt. Die Klemme 22 kann jedoch nicht über diese Position hinaus geschwenkt werden.

Außerdem kann der Halter 36 eine Klemmfläche 36a aufweisen, die mit der Innenseite des Rückenteils der Klemme 22 in reibende Anlage kommt, wenn die Klemme 22, wie es in Figur 6 veranschaulicht ist, in ihre Offenstellung überführt wird. Damit wird sichergestellt dass alle Klemmen 22, 22a usw., wenn sie in ihre Öffnungsstellung überführt sind, auch in dieser bleiben, so dass der Deckel 20 ungehindert abgenommen werden kann, ohne durch die Klemmen 22, 22a usw. behindert zu werden. Diese sind in Öffnungsstellung (Figur 6) so positioniert, dass kein Teil der Klemme 22 den Flansch 18 übergreift. In Schließstellung (Figur 4 und 5) sind sie hingegen so positioniert, dass die Schenkel 27, 28 den Rand 20 und den Flansch 18 übergreifen.

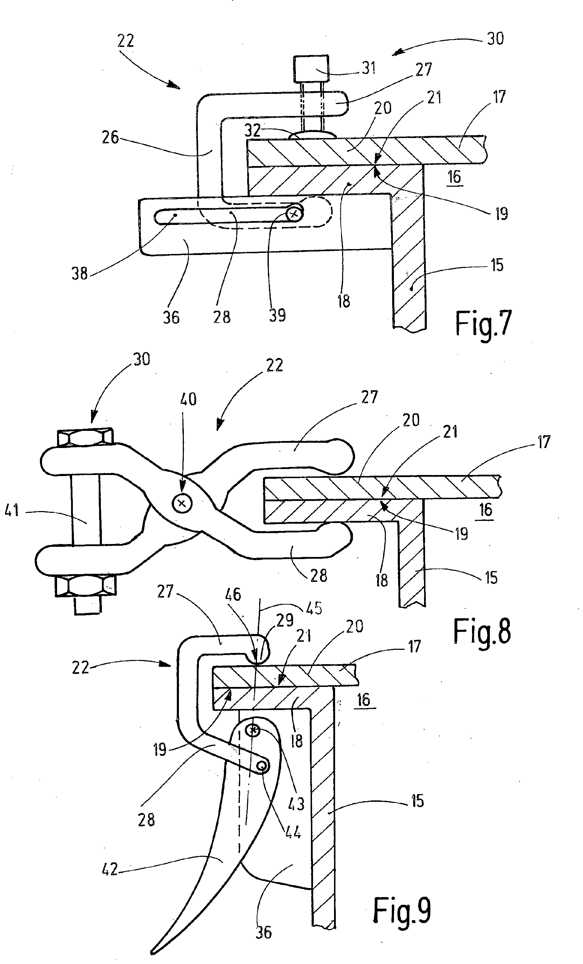

Figur 7 veranschaulicht eine abgewandelte, nicht erfindungsgemässe Klemme 22, für die die vorstehende Beschreibung unter Zugrundelegung der bereits eingeführten Bezugszeichen entsprechend gilt. Wiederum ist die Klemme 22 durch einen Halter 36 verliersicher an dem Gehäusekörper 15 gehalten. Der Halter 36 kann zwei Laschen umfassen, die den Schenkel 28 zwischen einander aufnehmen. Die Laschen weisen jeweils ein Langloch 38 auf, durch das sich ein in dem Schenkel 28 sitzender Stift 39 erstreckt. Das Langloch 38 kann etwas parallel zu dem Flansch 18 von dem Gehäusekörper 15 weg verlaufend angeordnet sein.

Der Stift 39 lagert die Klemme 22 schwenk- und verschiebbar an dem Flansch 18. Das Langloch 38 weist an seinem innenliegenden Ende, an dem sich der Stift 39 in einer Position befindet, an der die Klemme 22 festzuziehen ist, eine zu dem Flansch 18 hin gerichtete Erweiterung auf, so dass sich der Stift 39 zumindest hier auch vertikal, d.h. zu dem Flansch 18 hin und von diesem weg bewegen kann.

Durch Anziehen des Spannmittels 30 wird der Deckel 17 in Schließposition festgezogen. Wird das Spannmittel 30 gelöst, kann die Klemme 22 nach außen gefahren und/oder von dem Rand 20 weggeklappt werden, so dass der Deckel 17 ungehindert abgenommen werden kann.

Eine weiter abgewandelte, nicht erfindungsgemässe Ausführungsform der Klemme 22 veranschaulicht Figur 8. Die beiden Schenkel 27, 28 sind nach Art einer Zange bei einem Gelenk 40 miteinander verbunden, um zwischen einander den Rand 20 und den Flansch 18 zu klemmen. Die von dem Flansch 18 aus gesehen jenseits des Gelenks 40 liegenden Enden der Schenkel 27, 28 sind durch das Spannmittel 30 aufeinander zu spannbar. Das Spannmittel 30 wird beispielsweise durch eine Spannschraube 41 gebildet, die die beiden freien Enden der Schenkel 27, 28 aufeinander zu spannt.

Figur 9 veranschaulicht eine weitere, nicht erfindungsgemässe Klemme 22, die den Deckel 17 mit seinem Rand 20 gegen den Flansch 18 spannt. Die Klemme 22 weist wiederum zwei Schenkel 27, 28 auf, wobei einer der Schenkel, zum Beispiel der Schenkel 28, mittels einer Kniehebelanordnung spannbar ist. Dazu kann an dem Gehäusekörper 15 wiederum ein Halter 36 angeordnet sein, an dem ein Spannhebel 42 vorzugsweise um eine Achse 43 schwenkbar gelagert ist, die parallel zu der Flanschfläche 19 angeordnet ist. Der Schenkel 28 ist an dem Spannhebel 42 gelenkig gelagert, wobei die Gelenkachse 44 parallel zu der Schwenkachse 42 orientiert ist. Die Position der Gelenkachse 44 ist dabei gegen eine Verbindungslinie 45 versetzt, die eine Berührstelle 46 zwischen dem Schenkel 27 und dem Rand 20 mit der Schwenkachse 43 verbindet. In Spannposition liegt die Gelenkachse 44 zwischen der Verbindungsgeraden 45 und dem Gehäusekörper 15.

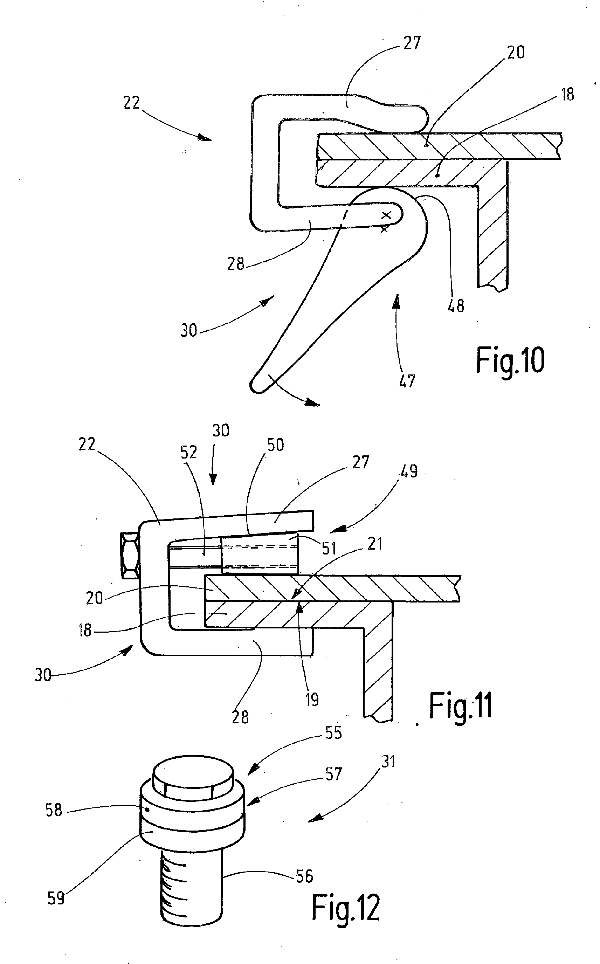

Neben der Kniehebelspanneinrichtung nach Figur 9 kann die Klemme 22, wie es Figur 10, zeigt auch durch eine Exzenterspanneinrichtung 47 in Spannposition überführt werden. Die Exzenterspanneinrichtung 47 umfasst beispielsweise einen an dem Schenkel 27 oder an dem Schenkel 28 angeordneten Exzenterhebel mit einer Nockenfläche 48 die auf den Flansch 18 oder den Rand 20 einwirkt.

Weiter alternativ kann als Spannmittel 30 für die Klemme 22 eine Keilspanneinrichtung 49 gemäß Figur 11 dienen. Dazu kann einer der Schenkel 27 oder 28 mit einer Keilfäche 50 versehen sein, die in einem spitzen Winkel zu der Flanschfläche 19 und der Randfläche 21 steht. Zwischen dieser Keilfläche 50 und dem Rand 20 bzw. dem Flansch 18 ist ein Keil 51 vorgesehen, der durch das Spannmittel, beispielsweise eine ziehend wirkende Schraube 52, festziehbar ist.

Die Spannmittel 30 nach den Figuren 8, 9, 10 oder 11 können alternativ zu der Spannschraube 31 bei den Klemmen nach Figur 2 bis 6 und allen im Zusammenhang mit diesen beschriebenen Ausführungsformen vorgesehen werden.

Optional ist es möglich, den Deckel 17 in Bezug auf den Flansch 18 zur Erzielung einer konturgleichen Ausrichtung mit diesem durch Positioniermittel 53, 54 auszurichten. Dazu können an dem Flansch 18 ein oder mehrere Strukturen vorgesehen sein, die dem Deckel 17, wenn er den Flansch berührt, seine Position in der von dem Flansch 19 festgelegten Ebene vorgeben. Solche Positioniermittel können ein, (bevorzugt) zwei oder mehrere Passstifte sein, die z.B. an dem Flansch 18 vorgesehen sind und den Rand 20 bei entsprechenden Passbohrungen durchgreifen. Die umgekehrte Anordnung ist möglich.

Bei einer bevorzugten Ausführungsform ist zur Erzeugung der Spannkraft, mit der der Rand 20 gegen den Flansch 18 gedrückt wird, ein Kraftbegrenzungsmittel vorgesehen. Dazu kann die Spannschraube 31 zwischen ihrem Kopf 55 und ihrem Schaft 56 eine Drehmomentbegrenzungseinrichtung 57 aufweisen, die zum Beispiel als Rutschkupplung oder als Ratsche ausgebildet ist. Zum Beispiel können die dem Kopf zugeordnete Kupplungshälfte 58 und die drehfest mit dem Schaft 56 verbundene Kupplungshälfte 59 jeweils an den aufeinander zuweisenden Seiten mit einer Verzahnung versehen sein, wobei die beiden Kupplungshälften 58, 59 durch ein geeignetes Spannmittel, zum Beispiel eine Feder aufeinander zu gespannt sind. Die Verzahnung kann eine Sägezahnverzahnung sein mit unterschiedlichen Zahnsteigungen bezüglich der beiden Drehrichtungen. Dadurch kann das Drehmoment zum Beispiel in Anzugrichtung begrenzt werden während es in Löserichtung unbegrenzt sein kann. Die in Löserichtung wirksamen Zahnflanken stehen dann zum Beispiel steil während die in Anzugrichtung im Eingriff stehenden Zahnflanken einen definierten, geringeren Anstieg aufweisen.

Das erfindungsgemäße Gehäuse der Schutzart druckfeste Kapselung weist einen Gehäusekörper 15 auf, der eine von einem Deckel 17 verschlossene Öffnung 16 aufweist. Die Öffnung 16 ist von einem Flansch 18 umgrenzt, der von dem Gehäusekörper 15 weg nach außen gerichtet ist. Auf dem Flansch 18 liegt der Rand 20 des Deckels 17 mit oder ohne Kompressionsdichtung flach auf. Der Rand 20 und der Flansch 18 sind beide vorzugsweise unterbrechungsfrei ausgebildet. Jedenfalls weisen sie keine Durchgangsöffnungen für Spannmittel auf. Zum Spannen des Rands 20 gegen den Flansch 18 sind Klemmen 22 vorgesehen, die den Rand 20 und den Flansch 18 nach Art von Schraubzwingen gegeneinander gepresst halten. Die Klemmen 22 sind mit lösbaren Spannmitteln 30 versehen und an dem Gehäusekörper 15 oder dem Deckel 17 vorzugsweise unverlierbar gehalten, wobei sie zwischen einer Schließposition, in der der Deckel 17 festgespannt ist und einer Öffnungsposition, in der sie den Deckel 17 nicht übergreifen und das Öffnen desselben ungehindert zulassen, bewegbar sind.

### Bezugszeichen:

- 14: Gehäuse
- 15: Gehäusekörper
- 16: Öffnung
- 17: Deckel
- 18: Flansch
- 19: Flanschfläche
- 20: Rand des Deckels 17
- 21: Randfläche
- 22: Klemmen, 22a, 22b usw.
- 23: oberes Scharnier
- 24: unteres Scharnier
- 25: Schwenkachse
- 26: Körper
- 27: oberer Schenkel
- 28: unterer Schenkel
- 29: Spannfläche
- 30: Spannmittel
- 31: Spannschraube
- 32: Fuß
- 33: Scharnier
- 34: Scharnierachse
- 35: Stift
- 36: Halter
- 36a: Klemmfläche
- L: Mittellinie
- 37: Anlagefläche
- 38: Langloch
- 39: Stift
- 40: Gelenk
- 41: Spannschraube
- 42: Spannhebel
- 43: Schwenkachse
- 44: Gelenkachse
- 45: Verbindungsgerade
- 46: Berührstelle
- 47: Exzenterspanneinrichtung
- 48: Nockenfläche
- 49: Keilspanneinrichtung
- 50: Keilfläche
- 51: Keil
- 52: Schraube
- 53: erstes Positioniermittel
- 54: zweites Positioniermittel
- 55: Kopf der Spannschraube 31
- 56: Schaft 56 der Spannschraube 31
- 57: Drehmomentbegrenzungseinrichtung
- 58: kopfseitige Kupplungshälfte
- 59: schaftseitige Kupplungshälfte

## Patentansprüche

1. Nicht gasdichtes Gehäuse (14) der Schutzart Druckfeste Kapselung zur Aufnahme von elektrischen oder elektronischen Komponenten, die Zündquellen darstellen können,
mit einem Gehäusekörper (15), der einen Innenraum zur Aufnahme der elektrischen oder elektronischen Komponenten umgrenzend ausgebildet ist und der eine von einem Flansch (18) umgrenzte Öffnung (16) sowie eine oder mehrere Öffnungen aufweist, die mit Flammensieben versehen sind, die aus Körpern bestehen, die enge Kanäle und/oder Poren aufweisen und somit gasdurchlässig sind,
mit einem Deckel (17), der einen auf dem Flansch (18) aufliegenden Rand (20) mit einer Randfläche (21) aufweist,
mit einer Anzahl Klemmen (22), die entlang des Flansches (18) und des Randes (20) in Abständen zueinander angeordnet und die den Rand (20) und den Flansch (18) umgreifend ausgebildet sind, um den Rand (20) mit oder ohne dazwischen angeordnete Dichtung gegen den Flansch (18) zu spannen,
wobei jede Klemme (22) eine Spannfläche (29) und ein dieser Spannfläche gegenüberliegendes Spannmittel (30) aufweist,
wobei die Klemmen (22) an dem Gehäusekörper (15) oder an dem Deckel (17) beweglich gehalten sind,
wobei die Klemmen (22) an dem Gehäusekörper (15) oder an dem Deckel (17) um eine Schwenkachse (34) schwenkbar gehalten sind, und jede Klemme (22) zwischen einer Öffnungsposition, in der sie den Rand (20) nicht umgreift, und einer Schließposition, in der sie den Rand (20) umgreift, beweglich gelagert ist,
wobei jeder Klemme (22) ein die Öffnungsposition festlegendes Mittel (36a) zugeordnet ist, die die Klemme (22) in der Öffnungsposition festlegt,
und jeder Klemme (22) ein die Schließposition festlegendes Mittel (37) zugeordnet ist, das dafür sorgt, dass die Klemme (22)in der gewünschten Soll-Position steht.

2. Gehäuse nach Anspruch 1, **dadurch gekennzeichnet, dass** der Flansch (20) eine ebene Flanschfläche (19) aufweist und dass der Deckel (17) eine ebene Randfläche (21) aufweist, die unmittelbar oder unter Zwischenlage einer Dichtung mit der Flanschfläche (19) in Anlage überführbar ist.

3. Gehäuse nach einem der vorstehenden Ansprüche, **dadurch gekennzeichnet, dass** der Deckel (17) über wenigstens ein Scharnier (23) mit dem Gehäusekörper (15) verbunden ist.

4. Gehäuse nach einem der vorstehenden Ansprüche, **dadurch gekennzeichnet, dass** an dem Gehäusekörper (15) und dem Deckel (17) Positioniermittel (53) zur deckungsgleichen Ausrichtung des Rands (20) und des Flansches (18) zueinander vorgesehen sind.

5. Gehäuse nach Anspruch 4, **dadurch gekennzeichnet, dass** die Positioniermittel (53) wenigstens zwei an dem Flansch (18) oder dem Rand (20) angeordnete Formkörper umfassen, denen in dem jeweils anderen von dem Flansch (18) oder dem Rand (20) angeordnete komplementäre Strukturen zugeordnet sind.

6. Gehäuse nach einem der vorstehenden Ansprüche, **dadurch gekennzeichnet, dass** die Klemmen (22) an dem Gehäusekörper (15) oder an dem Deckel (17) unverlierbar gehalten sind.

7. Gehäuse nach einem der vorstehenden Ansprüche , **dadurch gekennzeichnet, dass** die Schwenkachse (34) senkrecht zu dem Flansch (18) orientiert ist und jede Klemme (22) parallel oder quer zu der Schwenkachse (34) verschiebbar ist.

8. Gehäuse nach einem der vorstehenden Ansprüche, **dadurch gekennzeichnet, dass** jede Klemme (22) eine den Flansch (18) untergreifende oder den Deckel übergreifende Spannfläche (29) und ein dieser gegenüberliegendes Spannmittel (30) aufweist.

9. Gehäuse nach Anspruch 8, **dadurch gekennzeichnet, dass** das Spannmittel (30) weder den Rand (20) noch den Flansch (18) durchsetzend ausgebildet ist.

## Claims

1. Non-gastight housing (14) of the pressure-proof enclosure protection class, for receiving electrical or electronic components which may constitute ignition sources,
with a housing body (15) which is configured to delimit an interior for receiving the electrical or electronic components, and which has an opening (16) delimited by a flange (18) and one or more openings provided with flame screens comprising bodies which have narrow channels and/or pores and are hence gas-permeable,
with a cover (17) having an edge (20) with an edge face (21) lying on the flange (18),
with a number of clamps (22) which are arranged spaced apart from one another along the flange (18) and the edge (20), and which grip the edge (20) and the flange (18) in order to clamp the edge (20) against the flange (18) with or without interposed seal,
wherein each clamp (22) has a clamping face (29) and a clamping means (30) opposite this clamping face (29),
wherein the clamps (22) are held movably on the housing body (15) or on the cover (17),
wherein the clamps (22) are held pivotably about a pivot axis (34) on the housing body (15) or on the cover (17),
and each clamp (22) is mounted so as to be movable between an open position in which it does not grip the edge (20) and a closed position in which it grips the edge (20),
wherein a means (36a) defining the open position is assigned to each clamp (22) and fixes the clamp (22) in the open position,
and a means (37) defining the closed position is assigned to each clamp (22) and ensures that the clamp (22) stands in the desired nominal position.

2. Housing according to claim 1, **characterised in that** the flange (20) has a flat flange face (19), and that the cover (17) has a flat edge face (21) which can be brought into contact with the flange face (19) directly or with the interposition of a seal.

3. Housing according to one of the preceding claims, **characterised in that** the cover (17) is connected to the housing body (15) via at least one hinge (23).

4. Housing according to any of the preceding claims, **characterised in that** positioning means (53) for congruent mutual alignment of the edge (20) and the flange (18) are provided on the housing body (15) and on the cover (17).

5. Housing according to claim 4, **characterised in that** the positioning means (53) comprises at least two shaped bodies which are arranged on the flange (18) or on the edge (20) and to which are assigned complementary structures arranged on the respective other of the flange (18) or the edge (20).

6. Housing according to any of the preceding claims, **characterised in that** the clamps (22) are held captively on the housing body (15) or on the cover (17).

7. Housing according to any of the preceding claims, **characterised in that** the pivot axis (34) is oriented perpendicularly to the flange (18), and each clamp (22) is displaceable parallel or transversely to the pivot axis (34).

8. Housing according to any of the preceding claims, **characterised in that** each clamp (22) has a clamping face (29) extending below the flange (18) or over the cover, and a clamping means (30) opposite this.

9. Housing according to claim 8, **characterised in that** the clamping means (30) are formed so as not to penetrate through either the edge (20) or the flange (18).

## Revendications

1. Boîtier (14) non étanche au gaz, du type de protection à blindage résistant à la pression, destiné à accueillir des composants électriques ou électroniques qui peuvent constituer des sources d'inflammation,
comprenant un corps de boîtier (15) qui est réalisé de manière à délimiter un espace intérieur destiné à accueillir les composants électriques ou électroniques, et qui présente une ouverture (16) délimitée par une bride (18), ainsi qu'une ou plusieurs ouvertures dotées de tamis pare-flamme qui sont constitués de corps présentant des canaux et/ou des pores étroits et sont par conséquent perméables au gaz,
comprenant un couvercle (17) qui présente un bord (20) doté d'une surface de bord (21) et reposant sur la bride (18),
comprenant un certain nombre de pinces (22) qui sont disposées à distance les unes des autres le long de la bride (18) et du bord (20), et qui sont réalisées de manière à entourer le bord (20) et la bride (18) afin de serrer le bord (20) contre la bride (18), avec ou sans joint d'étanchéité intercalé,
dans lequel chaque pince (22) présente une surface de serrage (29) et un moyen de serrage (30) situé en vis-à-vis de cette surface de serrage,
dans lequel les pinces (22) sont tenues de façon mobile sur le corps de boîtier (15) ou sur le couvercle (17),
dans lequel les pinces (22) sont tenues sur le corps de boîtier (15) ou sur le couvercle (17) de manière à pouvoir pivoter autour d'un axe de pivotement (34),
et chaque pince (22) est montée de façon mobile entre une position d'ouverture, dans laquelle elle n'entoure pas le bord (20), et une position de fermeture dans laquelle elle entoure le bord (20),
dans lequel est associé à chaque pince (22), un moyen (36a) fixant la position d'ouverture qui fixe la pince (22) dans la position d'ouverture,
et dans lequel est associé à chaque pince (22), un moyen (37) fixant la position de fermeture, qui fait en sorte que la pince (22) occupe la position de consigne souhaitée.

2. Boîtier selon la revendication 1, **caractérisé en ce que** la bride (20) présente une surface de bride (19) plane, et **en ce que** le couvercle (17) présente une surface de bord (21) plane qui peut être amenée en appui contre la surface de bride (19), directement ou avec interposition d'un joint d'étanchéité.

3. Boîtier selon l'une des revendications précédentes, **caractérisé en ce que** le couvercle (17) est relié au corps de boîtier (15) par l'intermédiaire d'au moins une charnière (23).

4. Boîtier selon l'une des revendications précédentes, **caractérisé en ce que** sur le corps de boîtier (15) et sur le couvercle (17), sont prévus des moyens de positionnement (53) destinés à l'alignement coïncidant du bord (20) et de la bride (18) l'un par rapport à l'autre.

5. Boîtier selon la revendication 4, **caractérisé en ce que** les moyens de positionnement (53) comprennent au moins deux corps moulés qui sont disposés sur la bride (18) ou le bord (20) et auxquels sont associées des structures complémentaires disposées respectivement dans l'autre élément parmi la bride (18) et le bord (20).

6. Boîtier selon l'une des revendications précédentes, **caractérisé en ce que** les pinces (22) sont tenues de façon imperdable sur le corps de boîtier (15) ou sur le couvercle (17).

7. Boîtier selon l'une des revendications précédentes, **caractérisé en ce que** l'axe de pivotement (34) est orienté perpendiculairement à la bride (18), et que chaque pince (22) peut être déplacée parallèlement ou transversalement à l'axe de pivotement (34).

8. Boîtier selon l'une des revendications précédentes, **caractérisé en ce que** chaque pince (22) présente une surface de serrage (29) s'engageant sous la bride (18) ou s'engageant sur le couvercle (17), et un moyen de serrage (30) situé en vis-à-vis de cette surface.

9. Boîtier selon la revendication 8, **caractérisé en ce que** le moyen de serrage (30) est réalisé de manière à ne traverser ni le bord (20) ni la bride (18).
